(19) Europäisches Patentamt
European Patent Office
Office européen des brevets

(11) **EP 2 341 628 B1**

(12) **FASCICULE DE BREVET EUROPEEN**

(45) Date de publication et mention de la délivrance du brevet:
**22.02.2017 Bulletin 2017/08**

(51) Int Cl.:
***H03M 13/29*** *(2006.01)*

(21) Numéro de dépôt: **10194109.4**

(22) Date de dépôt: **08.12.2010**

(54) **Procédé de codage LDPC a redondance incrémentale**

LDPC-Kodierungsverfahren mit inkrementaler Redundanz

LDPC coding method for Incremental redundancy

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.12.2009 FR 0958787**

(43) Date de publication de la demande:
**06.07.2011 Bulletin 2011/27**

(73) Titulaire: **Commissariat à l'Énergie Atomique et aux Énergies Alternatives
75015 Paris (FR)**

(72) Inventeur: **Savin, Valentin
38000, GRENOBLE (FR)**

(74) Mandataire: **Ilgart, Jean-Christophe et al
BREVALEX
95, rue d'Amsterdam
75378 Paris Cedex 8 (FR)**

(56) Documents cités:
EP-A1- 1 531 552          US-A1- 2002 147 954
US-A1- 2004 123 229       US-A1- 2005 160 351

- Good, M.; Kschischang, F., R.: "Incremental Redundancy Via Check Splitting"", University of Toronto Online Database , 8 octobre 2007 (2007-10-08), pages 1-29, XP002640063, Toronto, CA Extrait de l'Internet: URL:http://www.comm.utoronto.ca/~frank/pap ers/GK07.pdf [extrait le 2011-06-01]

- JACOBSEN, N.; SONI, R.;: "Design of Rate-Compatible Irregular LDPC Codes Based on Edge Growth and Parity Splitting", VEHICULAR TECHNOLOGY CONFERENCE, 2007. VTC-2007, [Online] 30 octobre 2007 (2007-10-30), pages 1052-1056, XP002589811, Piscataway, NJ, USA IEEEXplore Extrait de l'Internet: URL:http://ieeexplore.ieee.org/stamp/stamp .jsp ?arnumber=04349877> [extrait le 2010-06-29]

- RAZAGHI, P.; WEI YU;: "Bilayer Low-Density Parity-Check Codes for Decode-and-Forward in Relay Channels", IEEE TRANSACTIONS ON INFORMATION THEORY, [Online] vol. 53, no. 10, octobre 2007 (2007-10), pages 3723-3739, XP002589816, Piscataway, NJ, USA IEEEXplore Extrait de l'Internet: URL:http://ieeexplore.ieee.org/stamp/stamp .jsp ?tp=&arnumber=4305411> [extrait le 2010-06-29]

- ZHAO B ET AL: "Distributed turbo coded diversity for relay channel", ELECTRONICS LETTERS, IEE STEVENAGE, GB, vol. 39, no. 10, 15 mai 2003 (2003-05-15), pages 786-787, XP006020339, ISSN: 0013-5194, DOI: DOI:10.1049/EL:20030526

- JING LI, KRISHNA R. NARAYANAN: "Rate-Compatible Low Density Parity Check Codes for Capacity-Approaching ARQ Schemes in Packet Data Communications", PROCEEDINGS OF COMMUNICATIONS, INTERNET AND INFORMATION TECHNOLOGY CONFERENCE (CIIT 2002), [Online] 20 novembre 2002 (2002-11-20), pages 201-206, XP002589813, St. Thomas, Virgin Island, US Citeseerx Extrait de l'Internet: URL:http://citeseerx.ist.psu.edu/viewdoc/d ownload?doi=10.1.1.72.9034&rep=rep1&type=p df> [extrait le 2010-06-28]

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 341 628 B1

- SANG HOON LEE; JIA AE SEOK; EON KYEONG JOO;: "Serial concatenation of LDPC and turbo code for the next generation mobile communications", WIRELESS AND OPTICAL COMMUNICATIONS NETWORKS, 2005. WOCN 2005. SECOND IFIP INTERNATIONAL CONFERENCE ON, [Online] 16 juin 2005 (2005-06-16), pages 425-427, XP002589815, Piscataway, NJ, USA IEEEXplore Extrait de l'Internet: URL:http://ieeexplore.ieee.org/stamp/stamp .jsp ?arnumber=01436061> [extrait le 2010-06-29]
- P. RAZAGHI ET AL.: "Bilayer low- density parity check codes for decode-and-forward", IEEE TRANS. ON INFORMATION THEORY, October 2007 (2007-10),
- H Behairy ET AL: "Analysis and design of parallel concatenated Gallager codes", Electronics Letters, 29 August 2002 (2002-08-29), pages 1-6, XP055212486, Stevenage Retrieved from the Internet: URL:http://search.proquest.com/docview/162 5469066 [retrieved on 2015-09-10]
- BEHAIRY H ET AL: "Parallel concatenated Gallager codes", ELECTRONICS LETTERS, IEE STEVENAGE, GB, vol. 36, no. 24, 23 November 2000 (2000-11-23), pages 2025-2026, XP006015951, ISSN: 0013-5194, DOI: 10.1049/EL:20001397
- RAZAGHI P ET AL: 'Bilayer Low-Density Parity-Check Codes for Decode-and-Forward in Relay Channels', [en ligne] vol. 53, no. 10, 31 Décembre 2007, pages 3723 - 3738, XP002589816 DOI: 10.1109/TIT.2007.904983 ISSN: 0018-9448 IEEE TRANSACTIONS ON INFORMATION THEORY, IEEE PRESS, USA Extrait de l'Internet: <URL:http://ieeexplore.ieee.org/stamp/stamp .js p?tp=&arnumber=4305411> [extrait le 2010-06-29]
- RAZAGHI P ET AL: "Bilayer Low-Density Parity-Check Codes for Decode-and-Forward in Relay Channels", IEEE TRANSACTIONS ON INFORMATION THEORY, IEEE PRESS, USA, vol. 51, no. 10, 1 October 2007 (2007-10-01), pages 3723-3739, XP011192543, ISSN: 0018-9448, DOI: 10.1109/TIT.2007.904983

**Description**

**DOMAINE TECHNIQUE**

La présente invention concerne le domaine des codes LDPC (*Low Density Parity Check*) binaires ou non binaires. Elle concerne également les codes correcteurs d'erreur ou ECC (*Error Correcting Codes*) à redondance incrémentale.

La présente invention peut s'appliquer à de nombreux domaines, tels que les systèmes de télécommunication à adaptation de liaison (*Link Adaptation*), le turbocodage, le codage distribué dans un réseau coopératif, les systèmes à protocole de transmission HARQ (*Hybrid Automatic Repeat reQuest*).

**ÉTAT DE LA TECHNIQUE ANTÉRIEURE**

Les codes LDPC ont été introduits par R. Gallager dans son article intitulé « Low density parity check codes » publié dans IEEE Trans. Inform. Theory, vol. IT-8, pages 21-28, 1962, et leurs intéressantes propriétés n'ont été redécouvertes que récemment, lorsque la puissance du décodage itératif a été mise en évidence dans les turbocodes.

Les codes LDPC sont particulièrement intéressants dans la mesure où ils permettent non seulement d'atteindre une capacité de correction proche de la limite de Shannon mais offrent également le meilleur compromis possible entre rendement et performance (proche de la borne de Gilbert-Varsharmov).

On sait que les codes LDPC sont des codes linéaires ayant pour propriété de présenter des matrices de contrôle de parité (désignées plus simplement par la suite « matrices de contrôle ») à faible densité d'éléments non nuls. On rappelle qu'un code linéaire $C$ est défini par sa matrice génératrice **G** ou de manière duale par sa matrice de parité **H** avec $\mathbf{H}\mathbf{G}^T = \mathbf{0}$. $X$ est un mot du code $C$ si et seulement si $\mathbf{H}X^T = 0$.

Les codes LDPC sont susceptibles d'une représentation par graphe bipartite. On appelle graphe bipartite un graphe non orienté dont l'ensemble des noeuds est constitué de deux sous-ensembles disjoints tels que deux noeuds quelconques d'un même sous-ensemble ne sont pas reliés entre eux par une arête du graphe.

Le graphe bipartite associé à un code LDPC est partitionné en un premier sous-ensemble de noeuds associés aux symboles constituant un mot de code, dits noeuds de variable, et un second sous-ensemble de noeuds associés aux contraintes du code, typiquement aux contrôles de parité, encore appelés noeuds de contrôle. Un graphe bipartite associé à un groupe de contraintes est encore appelé graphe de Tanner. Plus précisément, les noeuds de variable correspondent aux colonnes et les noeuds de contrôle aux lignes de la matrice de contrôle. Ainsi, un noeud de contrôle est relié à un noeud de variable par une arête du graphe si et seulement si le coefficient correspondant de la matrice de contrôle est non nul, autrement dit la matrice d'incidence du graphe correspond à la matrice de contrôle du code. De manière équivalente, les noeuds de variable représentent des bits du code (ou des symboles si le code est non binaire) et les noeuds de contrôle représentent des contrôles linéaires, dites aussi contraintes de parité, du code.

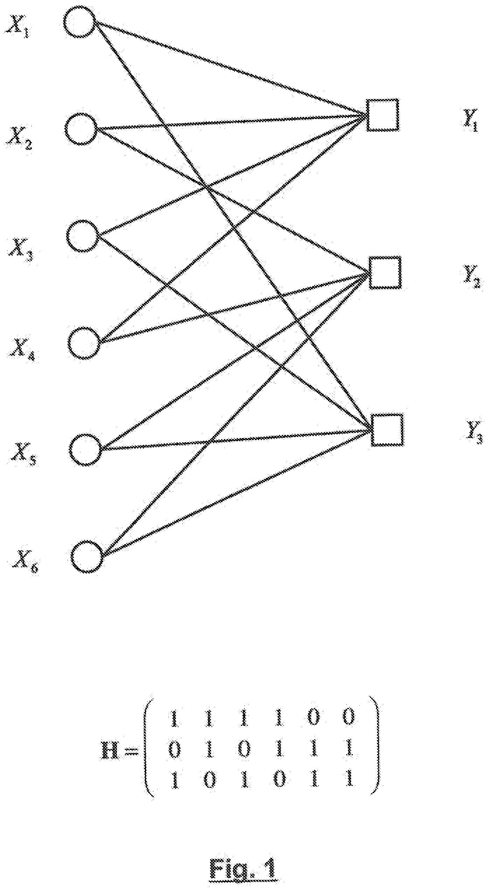

On a représenté en Fig. 1 le graphe bipartite d'un code binaire défini par une matrice de contrôle **H.** On remarque que le graphe comporte six noeuds de variable, $X_1,...,X_6$, représentant les six bits du code et trois noeuds de contrôle, $Y_1,..,Y_3$ représentant les trois contraintes de parité portant sur ces six bits.

Les codes LDPC peuvent être décodés au moyen d'un décodage itératif à passage de messages, dit aussi de type MP (*Message Passing*) ou BP (*Belief Propagation*). On trouvera une description générique de cette méthode de décodage dans la thèse de N. Wiberg intitulée « Codes and decoding on general graphs », 1996. Le décodage itératif à passage de messages est en fait une généralisation d'algorithmes bien connus dans le domaine du décodage à savoir l'algorithme « forward-backward » utilisé pour les turbocodes et l'algorithme de Gallager pour les codes LDPC. Le message transmis par un noeud de variable à un noeud de contrôle représente la « croyance » (belief) du noeud de variable quant à la valeur du bit codé correspondant (ou du symbole codé, lorsqu'il s'agit d'un code non binaire). Réciproquement, le message transmis par un noeud de contrôle à un noeud de variable représente la « croyance » du noeud de contrôle quant à la valeur du bit codé correspondant au noeud de variable destinataire (ou du symbole codé, lorsqu'il s'agit d'un code non binaire). En pratique, ces messages sont définis en termes de probabilités, ou de rapports de vraisemblance logarithmiques (LLR).

De nombreux algorithmes de décodage de codes LDPC ont été proposés dans l'état de la technique. Ils diffèrent soit par la nature des messages échangés (probabilités, LLRs), soit par la manière dont ils sont calculés, soit encore par la nature binaire ou non binaire du code. De manière non exhaustive, on peut citer les algorithmes de décodage « Sum-Product », « Min-Sum », « Min-Max », « Erasure Decoding », etc.. Par exemple, une méthode de décodage de type « Min-Max » a été décrite par V. Savin dans l'article « Min-Max decoding for non-binary LDPC codes » publié dans IEEE Symposium on Information Theory (ISIT), Toronto, Canada 2008.

La faible densité d'éléments non nuls de la matrice de contrôle d'un code LDPC se traduit par une faible densité de cycles courts au sein du graphe bipartite. Ces cycles ont tendance à engendrer une auto-confirmation des variables et des contrôles dans le processus de décodage itératif. On entend par là qu'une valeur erronée d'un noeud peut se voir confirmée par le simple fait que les messages que lui transmettent ses voisins dépendent eux-mêmes des messages que ce noeud leur transmet. Pour combattre ce phénomène d'auto-confirmation, le décodage doit respecter le principe dit d'information extrinsèque : un message transmis par un noeud expéditeur à un noeud destinataire est calculé à partir de tous les messages reçus par le noeud expéditeur à l'exception de celui en provenance du noeud destinataire. Toutefois, le respect du principe d'information extrinsèque n'exclut pas des auto-confirmations à des ordres plus élevés, dus aux cycles présents dans le graphe bipartite, ces auto-confirmations étant d'autant plus probables que les cycles sont courts.

On connaît par ailleurs de l'état de la technique le codage de correction d'erreur à redondance incrémentale. Un tel codage permet de pouvoir faire varier le degré de redondance et donc le débit du code à la demande. On entend par débit (ou rendement) du code le rapport entre le nombre de bits (ou de symboles) d'information par rapport au nombre de bits (ou de symboles) du code. Ainsi dans le cas d'un code binaire systématique, si $i$ est le nombre de bits d'information et si $p$ est le nombre de bits de parité, le débit du code est $R = \dfrac{i}{i+p}$ .

Une première manière connue de faire varier le débit d'un code est de le poinçonner avec un taux de poinçonnage plus ou moins important. Par exemple, si $(I,P)$ est un code systématique où $I$ représente les bits d'information et $P$ les bits de parité, le poinçonnage des bits de parité à des taux différents permet de faire varier la redondance du code de manière incrémentale.

Une seconde manière connue de réaliser un code à redondance incrémentale est de concaténer un nombre variable de codes élémentaires, encore appelés composantes du code, soit de manière série, soit de manière parallèle.

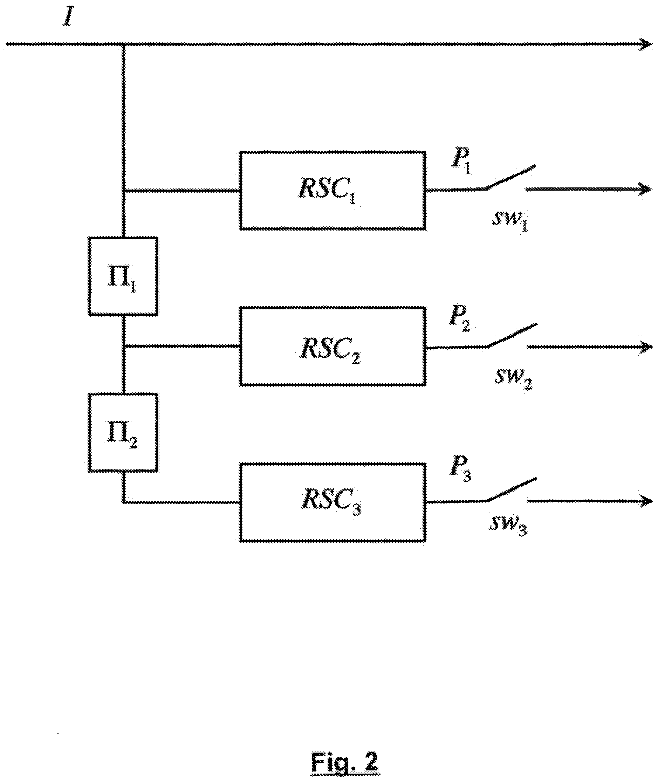

La Fig. 2 illustre un exemple de codage incrémental dans lequel on peut faire varier le nombre de composantes parallèles. Plus précisément, on a représenté ici un turbocode où $I$ est la partie systématique et où $P_1, P_2, P_3$, représentent les bits de parité fournis respectivement par un premier, un second et un troisième codeurs récursifs systématiques, notés $RSC_1$, $RSC_2$ et $RSC_3$. Les bits d'information sont entrelacés par un premier entrelaceur $\Pi_1$ en entrée du second codeur récursif systématique $RSC_1$, puis par un second entrelaceur $\Pi_2$ récursif systématique en entrée du troisième codeur récursif systématique $RSC_2$.

Les bits constitutifs des parties $I, P_1, P_2, P_3$ sont par exemple fournis ensuite à un modulateur binaire à symbole. Comme représenté symboliquement par les commutateurs $sw_1$, $sw_2$, $sw_3$, il est possible de sélectionner les différentes composantes du turbocode, par exemple de transmettre ou ne pas transmettre les bits de parité $P_2$.

Un autre exemple de codage à redondance incrémentale peut être illustré dans le contexte d'un réseau coopératif. On rappelle qu'un réseau coopératif est un réseau dans lequel l'information transmise par un terminal source $s$ à un terminal destinataire $d$ peut être relayée par un (ou plusieurs) terminal (terminaux) relais. Différentes stratégies de coopération ont été envisagées dans la littérature notamment selon le type d'information relayée par le terminal et le type de multiplexage entre l'information relayée et l'information propre du terminal relais.

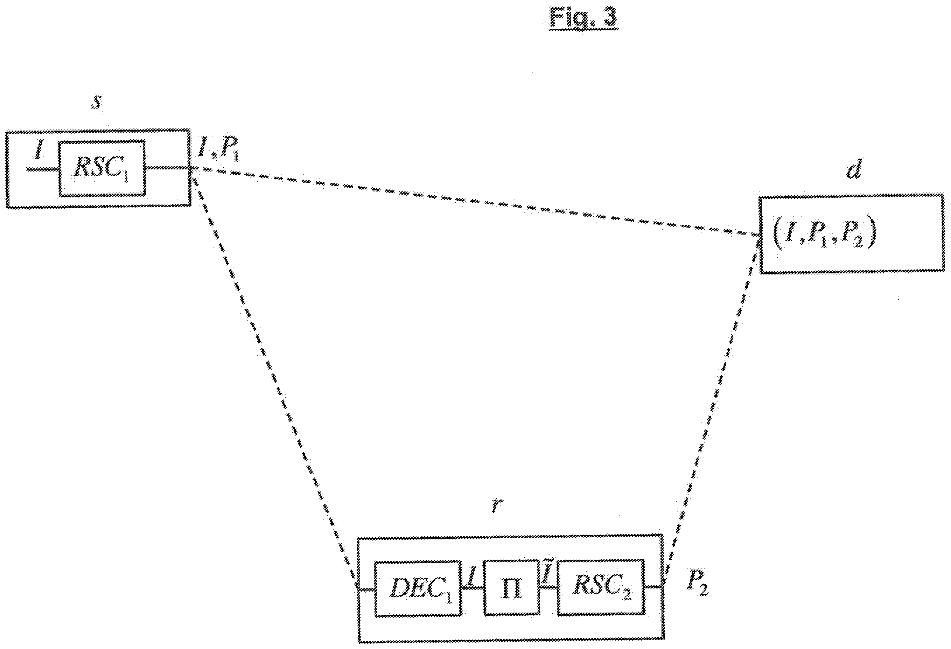

Nous avons représenté en Fig. 3 un exemple de stratégie de coopération, de type « *Decode and Forward* » au sein d'un réseau coopératif, tel que proposé dans l'article de B. Zhao et al. intitulé « Distributed turbo coded diversity for the relay channel », publié dans IEEE Electronics Letters, vol. 39, pages 786-787, Mai 2003.

Le terminal source $s$ transmet des bits d'information $I$ à l'aide d'un premier code systématique $C_1 = (I,P_1)$ au terminal destinataire $d$, autrement dit le mot de code $(I,P_1)$ où $P_1$ représente des bits de parité du code. Le terminal relais $r$ reçoit également $(I,P_1)$, via le canal de transmission $s$-$r$. Le terminal $r$ décode les données reçues pour récupérer les bits d'information $I$, entrelace ces bits d'information. L'information ainsi entrelacée, $\tilde{I}$, est codée à l'aide d'un second code systématique $C_2 = (\tilde{I},P_2)$. Les bits de parité $P_2$ sont ensuite transmis au destinataire $d$.

On comprend que les codes $C_1$ et $C_2$ constituent un turbocode parallèle $(I,P_1,P_2)$, distribué entre le terminal source et le terminal relais. Le terminal destinataire peut alors décoder les données reçues en utilisant un algorithme de décodage itératif (turbodécodage).

Enfin, le codage à redondance incrémentale trouve aussi à s'appliquer aux systèmes de télécommunications mobiles de type HARQ (*Hybrid Automatic Repeat reQuest*), encore dénommés pour cette raison IR-HARQ (*Incremental Redundancy HARQ*). Dans un tel système, un paquet de bits d'information $I$ est codé à l'aide d'un code correcteur d'erreurs. Lors de la première transmission du paquet sur le canal, seuls certains bits de parité, $P_1$, obtenus par exemple au moyen d'un poinçonnage du code, sont transmis avec les bits d'information. Si le récepteur ne peut corriger les erreurs du paquet à l'aide de $P_1$, une requête de retransmission est envoyée à l'émetteur. Celui-ci peut, selon le type d'implémentation, renvoyer de nouveaux bits de parité voire la totalité des bits de parité restants, $P_2$. Le récepteur corrige alors les erreurs du paquet à l'aide des bits $P_1$ reçus lors de la première transmission et des bits $P_2$ reçus lors de la seconde transmission. Ce processus de retransmission peut être itéré jusqu'à ce que la totalité des bits de parité du code aient été transmis. On comprend que $P_1$, $P_2$, ... constituent des incréments de redondance du code qui ne sont envoyés au coup par coup sur le canal de transmission que dans la mesure où ils sont nécessaires à la bonne réception du paquet.

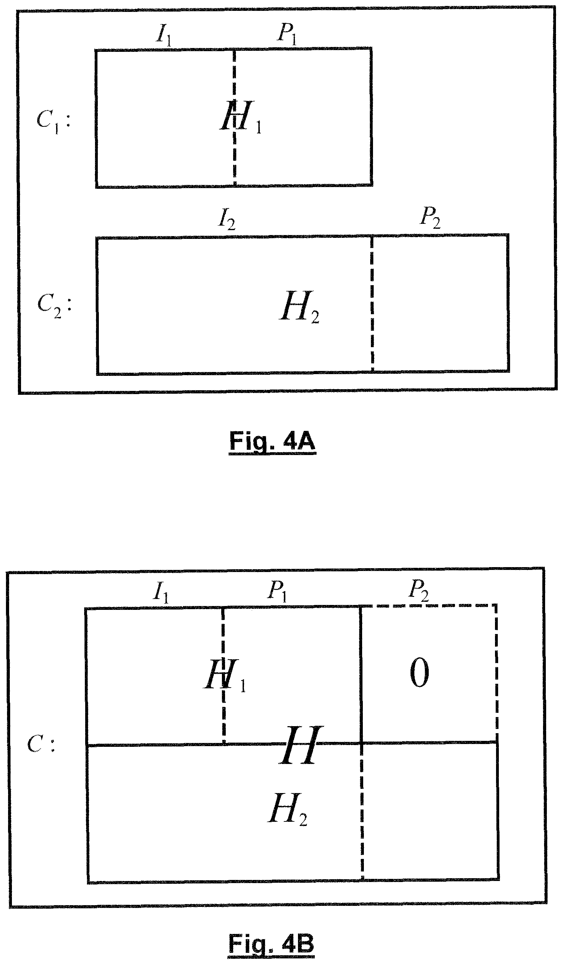

Il a été récemment proposé une méthode de codage à redondance incrémentale utilisant des codes LDPC dans l'article de P. Razaghi et al. intitulé « Bilayer low-density parity check codes for decode-and-forward », publié dans IEEE Trans. on Information Theory, Oct. 2007. Plus précisément, cette méthode de codage utilise deux codes LDPC $C_1$ et $C_2$, définis par deux matrices de parité $H_1$ et $H_2$, comme illustré en Fig. 4A. Le code $C_1$ permet de générer une séquence de bits de parité $P_1$ à partir d'une séquence de bits d'information $I_1$. Le code $C_2$ permet de générer une séquence de bits de parité $P_2$ à partir d'une séquence de bits d'information $I_2$. On note que la longueur de $I_2$ est égale à la somme des longueurs de $I_1$ et $P_1$.

Dans un réseau coopératif du type illustré en Fig. 3, le terminal source *s* code le paquet de bits d'information *I* en utilisant le code $C_1$ et génère une séquence de bits de parité, $P_1$. Le terminal source envoie alors ($I,P_1$) vers le terminal relais *r* et le terminal destinataire *d*. Le terminal relais *r* décode les données reçues à l'aide du code $C_1$ en corrigeant les erreurs éventuelles de transmission pouvant affecter *I* et $P_1$. Le terminal relais code ensuite ($I,P_1$) à l'aide du code $C_2$ et transmet un paquet de bits de parité $P_2$ vers le terminal destinataire *d*. Le terminal destinataire reçoit par conséquent ($I,P_1$) du terminal source et $P_2$ du terminal relais. Il décode alors le paquet ($I,P,P_2$) en utilisant un nouveau code *C*, de matrice de parité **H**, obtenue par concaténation des matrices $H_1$ et $H_2$, tel qu'illustré en Fig. 4B.

De manière similaire, dans le cadre d'un système de télécommunication de type IR-HARQ, un terminal source peut coder un paquet de bits d'information *I* à l'aide du code $C_1$. générant ainsi une séquence de bits de parité $P_1$. Le terminal source envoie le paquet ($I,P_1$) vers le terminal destinataire. Le terminal destinataire décode les données reçues à l'aide du code $C_1$, et corrige ainsi les erreurs de transmission éventuelles pouvant affecter *I* et $P_1$.

Si le décodage réussit, le destinataire récupère correctement le paquet de bits d'information *I*, et le terminal source peut continuer en transmettant le paquet d'information suivant. En revanche, si le décodage échoue, le terminal destinataire envoie une requête de retransmission au terminal source. Celui-ci code le paquet ($I,P_1$) à l'aide du code $C_2$ de la Fig. 4 et transmet la nouvelle séquence de bits de parité $P_2$ obtenue à partir de *I* et $P_1$. Le terminal destinataire décode alors le paquet ($I,P_1,P_2$) en utilisant le code concaténé *C*, de matrice de parité **H**, comme précédemment.

Le code LDPC concaténé *C* présente un rendement (ou débit) plus faible que chacun des codes élémentaires constitutifs $C_1$ et $C_2$. En effet si $R_1$ est le rendement du code $C_1$ et $R_2$ est le rendement du code $C_2$, le rendement du code concaténé *C* est de $R_1R_2$. Corrélativement, la puissance de correction du code *C* est supérieure à celle de chacun des codes élémentaires $C_1$ et $C_2$.

La capacité de correction d'un code LDPC est toutefois très dépendante de la densité des éléments non nuls dans sa matrice de contrôle. Ainsi, plus le rendement d'un code LDPC est faible, plus sa matrice de contrôle doit être déplétée. Autrement dit, lorsqu'on se place à une même distance par rapport à la limite théorique de Shannon, un code LDPC de rendement faible plus élevée dans la matrice $H_1$ que dans le reste de la matrice. Ainsi, la matrice **H** hérite de tous les cycles de la matrice $H_1$ alors que ceux-ci auraient pu être évités si l'on avait utilisé un code LDPC « natif » de rendement $R_1R_2$. L'existence de ces cycles dans la matrice **H** conduit à une dégradation des performances.

A l'opposé, le poinçonnage d'un code LDPC permet de construire à partir d'un code LDPC de rendement *R* un code LDPC poinçonné de rendement $R_1 > R$, mais les performances du code poinçonné se trouvent dégradées à cause de la présence dans le graphe associé au code de noeuds qui ne reçoivent aucune information du canal de transmission.

La demande européenne EP-A-1 531 552 concerne une méthode de turbocodage de symboles d'information utilisant un code LDPC à rendement variable. Le rendement variable du code est obtenu en mettant en service une branche ou deux branches du turbocodeur.

L'article de B. Behairy et al. intitulé « Parallel concatenated Gallager codes » publié dans Electronics Letters, 23 Nov. 2000, vol. 36, N° 24, pages 2025-2026, concerne également une méthode de turbocodage utilisant des codes LDPC concaténés en parallèle sans entrelaceur.

Le problème à la base de l'invention est de proposer une méthode de codage LDPC à redondance incrémentale utilisant un code LDPC tout en ne présentant pas les inconvénients précités, c'est-à-dire mettant en oeuvre des matrices de contrôle de faible densité et dépourvues de cycles courts.

## EXPOSÉ DE L'INVENTION

La présente invention est définie par une méthode de codage à redondance incrémentale telle que définie en revendication 1.

L'invention concerne encore une méthode de transmission de paquets dans un réseau de transmission de type coopératif telle que définie en revendication 2 ou en revendication 6.

Des modes avantageux de réalisation sont définis dans les revendications dépendantes.

## BRÈVE DESCRIPTION DES DESSINS

La Fig. 1 représente un exemple de graphe bipartite associé à un code LDPC binaire ;

La Fig. 2 représente schématiquement un exemple de turbocodage à redondance incrémentale ;

La Fig. 3 représente schématiquement un exemple de transmission dans un réseau coopératif ;

Les Fig. 4A et 4B représentent schématiquement des matrices de contrôle utilisées pour un codage à codes LDPC concaténés ;

Les Fig. 5A et 5B représentent respectivement un exemple de matrice de contrôle d'un code et une matrice obtenue par fractionnement de celle-ci ;

La Fig. 6 représente schématiquement une méthode de codage à redondance incrémentale selon un mode de réalisation de l'invention ;

La Fig. 7 représente schématiquement un turbocodage adaptatif utilisant une méthode de codage à redondance incrémentale selon un mode de réalisation de l'invention ;

La Fig. 8 représente schématiquement un système de transmission coopératif utilisant une méthode de codage à redondance incrémentale selon un mode de réalisation de l'invention.

## EXPOSÉ DÉTAILLÉ DE MODES DE RÉALISATION PARTICULIERS

Nous considérons dans la suite un code LDPC binaire ou non-binaire de matrice de contrôle **H.**

Dans le but de faciliter la compréhension de l'invention, la construction d'un code LDPC à redondance incrémentale sera tout d'abord illustrée dans un cas particulier.

Soit le code C défini par la matrice de contrôle **H :**

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ |
|---|---|---|---|---|---|---|---|---|---|---|---|---|---|---|---|
| 1 |   | 1 | 1 |   |   | 1 |   | 1 |   |   |   |   |   |   |   |
|   | 1 |   | 1 |   | 1 |   | 1 | 1 | 1 |   |   |   |   |   |   |
| 1 | 1 |   |   | 1 |   |   | 1 |   | 1 | 1 |   |   |   |   |   |
|   |   | 1 |   | 1 |   | 1 |   |   |   | 1 | 1 |   |   |   |   |
|   | 1 |   |   | 1 | 1 | 1 |   |   |   |   | 1 | 1 |   |   |   |
| 1 | 1 |   | 1 |   |   |   | 1 |   |   |   |   | 1 | 1 |   |   |
| 1 |   | 1 |   | 1 |   | 1 |   |   |   |   |   |   | 1 | 1 |   |
|   |   | 1 | 1 |   | 1 |   | 1 |   |   |   |   |   |   | 1 | 1 |

$$(1)$$

dans laquelle on a distingué par une ligne verticale la partie gauche relative aux bits d'information et la partie droite relative aux bits de parité. Plus précisément, les huit premières colonnes de la matrice correspondent aux huit bits de la séquence d' information $\mathbf{I} = (i_1, i_2, ..., i_8)$ et les huit dernières colonnes correspondent aux huit bits de la séquence de parité $\mathbf{P} = (p_1, p_2, ..., p_8)$. Les cases vides de la matrice (1) correspondent à des valeurs nulles. Les autres éléments définissent les équations de parité satisfaites par les seize bits du mot de code **c = (I,P₁)**. Ainsi la première ligne de la matrice **H** traduit la contrainte :

$$i_1 + i_3 + i_4 + i_7 + p_1 = 0 \qquad (2)$$

Et, de manière similaire, la seconde ligne traduit la contrainte :

$$i_2 + i_4 + i_6 + i_8 + p_1 + p_2 = 0 \qquad (3)$$

Une nouvelle matrice de contrôle, notée $\tilde{\mathbf{H}}$, est construite en « fractionnant » les contrôles de parité de la matrice **H.** Dans cet exemple, chaque contrôle de parité (c'est-à-dire chaque ligne de **H**) est scindé pour donner deux lignes de $\tilde{\mathbf{H}}$. Bien entendu, on comprendra qu'une ligne d'une matrice de contrôle **H** peut être scindée pour générer plusieurs lignes de $\tilde{\mathbf{H}}$.

On commence le processus en scindant le contrôle de parité associé à la première ligne de **H.** Pour ce faire, on déplace deux éléments non nuls de la première ligne, correspondant ici aux bits d'information $i_3$ et $i_4$, sur une nouvelle ligne :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ |
|---|---|---|---|---|---|---|---|---|---|---|---|---|---|---|---|
| 1 | | 1 | 1 | | | | 1 | 1 | | | | | | | |
| | 1 | | 1 | | 1 | | 1 | 1 | 1 | | | | | | |
| 1 | 1 | | | | | | 1 | | 1 | 1 | | | | | |
| | | 1 | | 1 | 1 | 1 | | | | 1 | 1 | | | | |
| | 1 | | | 1 | 1 | 1 | | | | | 1 | 1 | | | |
| 1 | 1 | | 1 | | | | 1 | | | | | 1 | 1 | | |
| 1 | | 1 | | 1 | | 1 | | | | | | | 1 | 1 | |
| | | 1 | 1 | | 1 | | 1 | | | | | | | 1 | 1 |

$$(4)$$

On obtient alors une matrice augmentée d'une ligne supplémentaire :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ |
|---|---|---|---|---|---|---|---|---|---|---|---|---|---|---|---|
| 1 | | | | | | 1 | | 1 | | | | | | | |
| | 1 | | 1 | | 1 | | 1 | 1 | 1 | | | | | | |
| 1 | 1 | | | 1 | | | 1 | | 1 | 1 | | | | | |
| | | 1 | | 1 | 1 | 1 | | | 1 | 1 | | | | | |
| | 1 | | | 1 | 1 | 1 | | | | 1 | 1 | | | | |
| 1 | 1 | | 1 | | | | 1 | | | | 1 | 1 | | | |
| 1 | | 1 | | 1 | | 1 | | | | | | 1 | 1 | | |
| | | 1 | 1 | | 1 | | 1 | | | | | | 1 | 1 | |
| | | 1 | 1 | | | | | | | | | | | | |

$$(5)$$

Le contrôle de parité exprimé par (2) peut être réécrit de la manière équivalente :

$$
\begin{aligned}
i_1 + i_7 + p_1 &= q_1 \\
i_3 + i_4 &= q_1
\end{aligned}
\qquad (6)
$$

en introduisant un nouveau bit de parité $q_1$. Autrement dit, le contrôle de parité (2) est désormais scindé en deux contrôles de parité « partiels »:

$$i_1 + i_7 + p_1 + q_1 = 0 \qquad (7\text{-}1)$$

$$i_3 + i_4 + q_1 = 0 \qquad (7\text{-}2)$$

ce qui se traduit par une nouvelle matrice de contrôle, présentant une colonne supplémentaire :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ | $q_1$ |
|---|---|---|---|---|---|---|---|---|---|---|---|---|---|---|---|---|
| 1 | | | | | | 1 | | 1 | | | | | | | | 1 |
| | 1 | | 1 | | 1 | | 1 | 1 | 1 | | | | | | | |
| 1 | 1 | | | 1 | | | 1 | | 1 | 1 | | | | | | |
| | | 1 | | 1 | 1 | 1 | | | | 1 | 1 | | | | | |
| | 1 | | | 1 | 1 | 1 | | | | | 1 | 1 | | | | |
| 1 | 1 | | 1 | | | | 1 | | | | | 1 | 1 | | | |
| 1 | | 1 | | 1 | | 1 | | | | | | | 1 | 1 | | |
| | | 1 | 1 | | 1 | | 1 | | | | | | | 1 | 1 | |
| | | 1 | 1 | | | | | | | | | | | | | 1 |

$$(8)$$

Le premier élément de la colonne relative à $q_1$ traduit le premier contrôle partiel de parité défini en (7-1), le neuvième élément de cette colonne traduit le second contrôle de parité défini en (7-2). Le processus de fractionnement peut être poursuivi avec la seconde ligne, en déplaçant par exemple trois éléments non nuls de cette ligne correspondant aux bits d'information $i_2$, $i_6$ et au bit de parité $p_1$ :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ | $q_1$ |
|---|---|---|---|---|---|---|---|---|---|---|---|---|---|---|---|---|
| 1 | | | | | | 1 | | 1 | | | | | | | | 1 |
| | | | 1 | | | | 1 | | 1 | | | | | | | |
| 1 | 1 | | | 1 | | | 1 | | 1 | 1 | | | | | | |
| | | 1 | | 1 | 1 | 1 | | | | 1 | 1 | | | | | |
| | | | | 1 | 1 | 1 | | | | | 1 | 1 | | | | |
| 1 | 1 | | 1 | | | | 1 | | | | | 1 | 1 | | | |
| 1 | | 1 | | 1 | | 1 | | | | | | | 1 | 1 | | |
| | | 1 | 1 | | 1 | | 1 | | | | | | | 1 | 1 | |
| | | 1 | 1 | | | | | | | | | | | | | 1 |

$$(9)$$

On obtient ainsi une matrice de contrôle augmentée d'une ligne supplémentaire :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ | $q_1$ |
|---|---|---|---|---|---|---|---|---|---|---|---|---|---|---|---|---|
| 1 | | | | | | 1 | | 1 | | | | | | | | 1 |
| | | | 1 | | | | 1 | | 1 | | | | | | | |
| 1 | 1 | | | 1 | | | 1 | | 1 | 1 | | | | | | |
| | | 1 | | 1 | 1 | 1 | | | | 1 | 1 | | | | | |
| | 1 | | | 1 | 1 | 1 | | | | | 1 | 1 | | | | |
| 1 | 1 | | 1 | | | | 1 | | | | | 1 | 1 | | | |
| 1 | | 1 | | 1 | | 1 | | | | | | | 1 | 1 | | |
| | | 1 | 1 | | 1 | | 1 | | | | | | | 1 | 1 | |
| | | 1 | 1 | | | | | | | | | | | | | 1 |
| | 1 | | | | 1 | | | 1 | | | | | | | | |

$$(10)$$

Le contrôle de parité (3) peut encore s'exprimer de manière équivalente sous la forme :

$$i_4 + i_8 + p_2 = q_2$$
$$i_2 + i_6 + p_1 = q_2 \qquad\qquad (11)$$

Autrement dit, le contrôle de parité (3) est désormais scindé en deux contrôles de parité « partiels » :

$$i_4 + i_8 + p_2 + q_2 = 0 \qquad\qquad (12\text{-}1)$$

$$i_2 + i_6 + p_1 + q_2 = 0 \qquad\qquad (12\text{-}2)$$

où $q_2$ est un nouveau bit de parité. Ceci se traduit par l'ajout d'une colonne supplémentaire dans la matrice de contrôle :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ | $q_1$ | $q_2$ |
|---|---|---|---|---|---|---|---|---|---|---|---|---|---|---|---|---|---|
| 1 | | | | | | | 1 | 1 | | | | | | | | 1 | |
| | | 1 | | | | | 1 | | 1 | | | | | | | | 1 |
| 1 | 1 | | | 1 | | | 1 | | 1 | 1 | | | | | | | |
| | | | 1 | | 1 | 1 | 1 | | | 1 | 1 | | | | | | |
| | | 1 | | | 1 | 1 | 1 | | | | 1 | 1 | | | | | |
| 1 | 1 | | 1 | | | | 1 | | | | | 1 | 1 | | | | |
| 1 | | | 1 | | 1 | | 1 | | | | | | 1 | 1 | | | |
| | | 1 | 1 | | 1 | | 1 | | | | | | | 1 | 1 | | |
| | | 1 | 1 | | | | | 1 | | | | | | | | 1 | |
| | | 1 | | | 1 | | 1 | | | | | | | | | | 1 |

$$(13)$$

où le second (resp. le dixième) élément de la colonne relative à $q_2$ traduit le premier (resp. le second) contrôle partiel de parité défini en (12-1) (resp. en (12-2)).

On peut poursuivre le processus de fractionnement et créer des bits de parité supplémentaires $q_3$ à $q_8$. Au terme du processus, on obtient une matrice de contrôle $\tilde{H}$ :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ | $q_1$ | $q_2$ | $q_3$ | $q_4$ | $q_5$ | $q_6$ | $q_7$ | $q_8$ |
|---|---|---|---|---|---|---|---|---|---|---|---|---|---|---|---|---|---|---|---|---|---|---|---|
| 1 |   |   |   |   |   | 1 |   | 1 |   |   |   |   |   |   |   | 1 |   |   |   |   |   |   |   |
|   |   | 1 |   |   |   |   | 1 |   | 1 |   |   |   |   |   |   |   | 1 |   |   |   |   |   |   |
|   | 1 |   |   |   |   |   | 1 |   |   | 1 |   |   |   |   |   |   |   | 1 |   |   |   |   |   |
|   |   |   | 1 |   | 1 |   |   |   |   |   | 1 |   |   |   |   |   |   |   | 1 |   |   |   |   |
|   |   |   |   | 1 |   | 1 |   |   |   |   |   | 1 |   |   |   |   |   |   |   | 1 |   |   |   |
|   | 1 |   | 1 |   |   |   |   |   |   |   |   |   | 1 |   |   |   |   |   |   |   | 1 |   |   |
| 1 |   |   |   | 1 |   |   |   |   |   |   |   |   |   | 1 |   |   |   |   |   |   |   | 1 |   |
|   | 1 |   |   | 1 |   |   |   |   |   |   |   |   |   |   | 1 |   |   |   |   |   |   |   | 1 |
|   |   | 1 | 1 |   |   |   |   |   |   |   |   |   |   |   |   | 1 |   |   |   |   |   |   |   |
|   | 1 |   |   |   | 1 |   |   | 1 |   |   |   |   |   |   |   |   | 1 |   |   |   |   |   |   |
| 1 |   |   |   | 1 |   |   |   |   |   |   |   |   |   |   |   |   |   | 1 |   |   |   |   |   |
|   |   |   | 1 |   | 1 |   |   |   |   |   |   |   |   |   |   |   |   |   | 1 |   |   |   |   |
|   | 1 |   |   |   | 1 |   |   |   |   |   |   |   |   |   |   |   |   |   |   | 1 |   |   |   |
| 1 |   |   |   |   |   | 1 |   |   |   |   |   |   |   |   |   |   |   |   |   |   | 1 |   |   |
|   |   |   | 1 |   |   | 1 |   |   |   |   |   |   |   |   |   |   |   |   |   |   |   | 1 |   |
|   |   | 1 |   |   |   | 1 |   |   |   |   |   |   |   |   |   |   |   |   |   |   |   |   | 1 |

$$(14)$$

Dans l'exemple précédent, chaque contrôle de parité a été scindé en deux contrôles partiels. Comme indiqué plus haut, le fractionnement peut être de degré plus élevé. Ainsi la seconde ligne de la matrice **H** peut être scindée en trois pour donner naissance à trois lignes supplémentaires. Par exemple, si l'on considère la matrice après le fractionnement de la première ligne en (8) et que l'on déplace les éléments non nuls de la seconde ligne correspondant aux bits $i_2$ et $p_1$ sur une première ligne supplémentaire et ceux correspondant aux bits $i_6$ et $i_8$ sur une seconde ligne supplémentaire :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ | $q_1$ |
|---|---|---|---|---|---|---|---|---|---|---|---|---|---|---|---|---|
| 1 |   |   |   |   |   | 1 |   | 1 |   |   |   |   |   |   |   | 1 |
|   | 1 |   | 1 |   | 1 |   | 1 | 1 | 1 |   |   |   |   |   |   |   |
| 1 | 1 |   |   | 1 |   |   | 1 |   | 1 | 1 |   |   |   |   |   |   |
|   |   | 1 |   | 1 | 1 | 1 |   |   |   | 1 | 1 |   |   |   |   |   |
|   |   | 1 |   | 1 | 1 | 1 |   |   |   |   | 1 | 1 |   |   |   |   |
| 1 | 1 |   | 1 |   |   |   | 1 |   |   |   |   | 1 | 1 |   |   |   |
| 1 |   | 1 |   | 1 |   | 1 |   |   |   |   |   |   | 1 | 1 |   |   |
|   | 1 | 1 |   |   | 1 |   | 1 |   |   |   |   |   |   | 1 | 1 |   |
|   | 1 | 1 | 1 |   |   | 1 | 1 |   |   |   |   |   |   |   |   | 1 |

$$(15)$$

on obtient une nouvelle matrice :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ | $q_1$ |
|---|---|---|---|---|---|---|---|---|---|---|---|---|---|---|---|---|
| 1 |   |   |   |   |   | 1 |   | 1 |   |   |   |   |   |   |   | 1 |
|   |   | 1 |   |   |   |   |   |   | 1 |   |   |   |   |   |   |   |
| 1 | 1 |   |   | 1 |   |   | 1 | 1 | 1 |   |   |   |   |   |   |   |
|   |   | 1 |   | 1 | 1 | 1 |   |   |   | 1 | 1 |   |   |   |   |   |
|   |   | 1 |   | 1 | 1 | 1 |   |   |   |   |   | 1 | 1 |   |   |   |
| 1 | 1 |   | 1 |   |   |   | 1 |   |   |   |   | 1 | 1 |   |   |   |
| 1 |   |   | 1 |   |   | 1 |   |   |   |   |   |   | 1 | 1 |   |   |
|   |   | 1 | 1 |   | 1 |   | 1 |   |   |   |   |   |   | 1 | 1 |   |
|   |   | 1 | 1 |   |   |   |   |   |   |   |   |   |   |   |   | 1 |
|   | 1 |   |   |   |   |   |   | 1 |   |   |   |   |   |   |   |   |
|   |   |   |   |   | 1 |   | 1 |   |   |   |   |   |   |   |   |   |

$$(16)$$

Le contrôle de parité (3) peut s'exprimer de manière équivalente sous la forme du système d'équations :

$$i_4 + p_2 = q_2$$
$$i_2 + p_1 = q_3 \tag{17}$$
$$i_6 + i_8 + q_2 + q_3 = 0$$

autrement dit, sous la forme de trois contrôles de parité partiels :

$$i_4 + p_2 + q_2 = 0$$
$$i_2 + p_1 + q_3 = 0 \tag{18}$$
$$i_6 + i_8 + q_2 + q_3 = 0$$

en introduisant les deux nouveaux bits de parité $q_2$ et $q_3$. La matrice de contrôle présente alors deux colonnes supplémentaires, comme indiqué ci-après :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ | $q_1$ | $q_2$ | $q_3$ |
|---|---|---|---|---|---|---|---|---|---|---|---|---|---|---|---|---|---|---|
| 1 |   |   |   |   |   | 1 |   | 1 |   |   |   |   |   |   |   | 1 |   |   |
|   |   | 1 |   |   |   |   |   |   | 1 |   |   |   |   |   |   |   | 1 |   |
| 1 | 1 |   |   | 1 |   |   | 1 | 1 | 1 |   |   |   |   |   |   |   |   |   |
|   |   | 1 |   | 1 | 1 | 1 |   |   |   | 1 | 1 |   |   |   |   |   |   |   |
|   |   | 1 |   | 1 | 1 | 1 |   |   |   |   |   | 1 | 1 |   |   |   |   |   |
| 1 | 1 |   | 1 |   |   |   | 1 |   |   |   |   | 1 | 1 |   |   |   |   |   |
| 1 |   |   | 1 |   |   | 1 |   |   |   |   |   |   | 1 | 1 |   |   |   |   |
|   |   | 1 | 1 |   | 1 |   | 1 |   |   |   |   |   |   | 1 | 1 |   |   |   |
|   |   | 1 | 1 |   |   |   |   |   |   |   |   |   |   |   |   | 1 |   |   |
|   | 1 |   |   |   |   |   |   | 1 |   |   |   |   |   |   |   |   |   | 1 |
|   |   |   |   |   | 1 |   | 1 |   |   |   |   |   |   |   |   |   | 1 | 1 |

$$(19)$$

On comprendra que différents contrôles de parité puissent être scindés en des nombres différents de contrôles partiels. Par exemple, plus une ligne comporte d'éléments non nuls, plus finement pourra-telle être fragmentée. On peut ainsi obtenir des lignes comportant un faible nombre d'éléments non nuls.

A l'inverse, si nécessaire, il est toujours possible de rajouter des éléments non nuls dans la matrice de contrôle. Par exemple si l'on scinde la troisième ligne de **H** en déplaçant les éléments non nuls correspondant aux bits $i_1$ et $i_8$ sur une première ligne supplémentaire et les éléments non nuls correspondant aux bits $i_5$ et $p_2$ sur une seconde ligne supplémentaire :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ | $q_1$ | $q_2$ | $q_3$ |
|---|---|---|---|---|---|---|---|---|---|---|---|---|---|---|---|---|---|---|
| 1 |   |   |   |   |   | 1 |   | 1 |   |   |   |   |   |   |   | 1 |   |   |
|   |   | 1 |   |   |   |   |   |   | 1 |   |   |   |   |   |   |   | 1 |   |
| 1 | 1 |   |   | 1 |   |   | 1 |   | 1 |   |   |   |   |   |   |   |   |   |
|   |   | 1 |   | 1 | 1 | 1 |   |   |   | 1 | 1 |   |   |   |   |   |   |   |
|   | 1 |   |   | 1 | 1 | 1 |   |   |   |   |   | 1 | 1 |   |   |   |   |   |
| 1 | 1 |   | 1 |   |   |   | 1 |   |   |   |   | 1 | 1 |   |   |   |   |   |
| 1 |   | 1 |   | 1 |   | 1 |   |   |   |   |   |   |   | 1 | 1 |   |   |   |
|   | 1 | 1 |   | 1 |   |   | 1 |   |   |   |   |   |   | 1 | 1 |   |   |   |
| 1 |   | 1 |   |   |   |   |   |   |   |   |   |   |   |   |   | 1 |   |   |
|   | 1 |   |   |   |   |   |   | 1 |   |   |   |   |   |   |   |   |   | 1 |
|   |   |   |   |   | 1 |   |   |   |   |   |   |   |   |   |   |   | 1 | 1 |

$$(20)$$

on obtient la nouvelle matrice :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ | $q_1$ | $q_2$ | $q_3$ |
|---|---|---|---|---|---|---|---|---|---|---|---|---|---|---|---|---|---|---|
| 1 |   |   |   |   |   | 1 |   | 1 |   |   |   |   |   |   |   | 1 |   |   |
|   |   | 1 |   |   |   |   |   |   | 1 |   |   |   |   |   |   |   | 1 |   |
|   | 1 |   |   |   |   |   |   |   |   | 1 |   |   |   |   |   |   |   |   |
|   |   | 1 |   | 1 | 1 | 1 |   |   |   | 1 | 1 |   |   |   |   |   |   |   |
|   | 1 |   |   | 1 | 1 | 1 |   |   |   |   |   | 1 | 1 |   |   |   |   |   |
| 1 | 1 |   | 1 |   |   |   | 1 |   |   |   |   | 1 | 1 |   |   |   |   |   |
| 1 |   | 1 |   | 1 |   | 1 |   |   |   |   |   |   |   | 1 | 1 |   |   |   |
|   | 1 | 1 |   | 1 |   |   | 1 |   |   |   |   |   |   | 1 | 1 |   |   |   |
|   |   | 1 | 1 |   |   |   |   |   |   |   |   |   |   |   |   | 1 |   |   |
|   | 1 |   |   |   |   |   |   |   | 1 |   |   |   |   |   |   |   |   | 1 |
|   |   |   |   | 1 |   | 1 |   |   |   |   |   |   |   |   |   |   | 1 | 1 |
| 1 |   |   |   |   |   | 1 |   |   |   |   |   |   |   |   |   |   |   |   |
|   |   |   |   | 1 |   |   |   | 1 |   |   |   |   |   |   |   |   |   |   |

$$(21)$$

Le contrôle de parité correspondant à la troisième ligne de la matrice **H** peut s'exprimer de la manière suivante :

$$i_1 + i_2 + i_5 + i_8 + p_2 + p_3 = 0 \qquad (22)$$

On peut insérer une variable dans la contrainte (22), par exemple le bit d'information systématique $i_3$ :

$$\left(i_2 + p_3 + i_3\right) + \left(i_1 + i_8 + i_3\right) + \left(i_5 + p_2\right) = 0 \qquad (23)$$

soit, en introduisant les nouveaux bits de parité $q_4 = i_2 + p_3 + i_3$ et $q_5 = i_1 + i_8 + i_3$ :

$$i_2 + p_3 + i_3 + q_4 = 0 \qquad (24\text{-}1)$$

$$i_1 + i_8 + i_3 + q_5 = 0 \qquad (24\text{-}2)$$

$$i_5 + p_2 + q_4 + q_5 = 0 \qquad (24\text{-}3)$$

On remarque que le bit $i_3$ apparaît dans le contrôle partiel (24-1) et que, corrélativement, il apparaît aussi dans le contrôle partiel (24-2). La matrice de contrôle $\tilde{\mathbf{H}}$ comporte ainsi deux colonnes supplémentaires respectivement associées à $q_4$ et $q_5$. A la différence des lignes précédentes un élément non nul a été introduit (ici dans la troisième et la douzième lignes de la matrice) :

| $i_1$ | $i_2$ | $i_3$ | $i_4$ | $i_5$ | $i_6$ | $i_7$ | $i_8$ | $p_1$ | $p_2$ | $p_3$ | $p_4$ | $p_5$ | $p_6$ | $p_7$ | $p_8$ | $q_1$ | $q_2$ | $q_3$ | $q_4$ | $q_5$ |
|---|---|---|---|---|---|---|---|---|---|---|---|---|---|---|---|---|---|---|---|---|
| 1 | | | | | | 1 | | 1 | | | | | | | | 1 | | | | |
| | | 1 | | | | | | | 1 | | | | | | | | 1 | | | |
| | 1 | 1 | | | | | | | | | 1 | | | | | | | | 1 | |
| | | | 1 | | 1 | 1 | 1 | | | 1 | 1 | | | | | | | | | |
| | | | 1 | | 1 | 1 | 1 | | | | 1 | 1 | | | | | | | | |
| 1 | 1 | | 1 | | | | 1 | | | | | 1 | 1 | | | | | | | |
| 1 | | 1 | | 1 | | | 1 | | | | | | 1 | 1 | | | | | | |
| | | 1 | 1 | | 1 | | 1 | | | | | | | 1 | 1 | | | | | |
| | | 1 | 1 | | | | | | | | | | | | | 1 | | | | |
| | 1 | | | | | | | | 1 | | | | | | | | | 1 | | |
| | | | 1 | | | | 1 | | | | | | | | | | | 1 | 1 | |
| 1 | | 1 | | | | | 1 | | | | | | | | | | | | | 1 |
| | | | | 1 | | | | | 1 | | | | | | | | | | 1 | 1 |

$$(25)$$

Nous décrirons dans la suite le cas général d'une méthode de codage à redondance incrémentale à l'aide d'un code dont la matrice de contrôle est obtenue par fractionnement de la matrice de contrôle $\mathbf{H}$ d'un code LDPC, $C$. Ce code n'est pas nécessairement binaire, par conséquent les éléments de $\mathbf{H}$ peuvent être des éléments d'un corps de Galois à $q$ éléments, $GF(q)$, ou de manière plus générale des éléments d'un groupe agissant sur l'alphabet non-binaire du code. Le code LDPC n'est pas non plus nécessairement systématique, c'est-à-dire les variables ne sont pas nécessairement les symboles d'information eux-mêmes mais plus généralement des combinaisons linéaires de ceux-ci (données par la matrice génératrice $\mathbf{G}$ du code). On notera que lorsque le code n'est pas systématique, la matrice de parité $\mathbf{H}$ ne se divise pas en une première partie relative aux symboles d'information et une seconde partie relative aux symboles de parité, comme dans l'exemple précédent.

La matrice $\mathbf{H}$ est supposée être de taille $M \times N$. Soit une matrice $\tilde{\mathbf{H}}$ de taille $\tilde{M} \times \tilde{N}$ avec $\tilde{M} \geq M$ et $\tilde{N} \geq N$. On dira que des lignes $L_{i_1}, L_{i_2}, ..., L_{i_k}$ de $\tilde{\mathbf{H}}$ sont obtenues par fractionnement, d'une ligne $R_j$ de $\mathbf{H}$ s'il existe un sous-ensemble $E \subseteq [1{:}\tilde{N}] \equiv \{1,...,\tilde{N}\}$, de cardinal $N$ tel que :

$$L_{i_1} \oplus L_{i_2} \oplus \ldots \oplus L_{i_k} \Big|_E = R_j \qquad (26)$$

et

$$L_{i_1} \oplus L_{i_2} \oplus \ldots \oplus L_{i_k} \Big|_{[1{:}\tilde{N}] \setminus E} = 0 \qquad (27)$$

où pour tout vecteur $V = (v_1,...,v_{\tilde{N}})$ de taille $\tilde{N}$, on note $V|_E$ le vecteur des $N$ composantes de $V$ dont les indices appartiennent à $E$ et $V|_{[1:\tilde{N}]\backslash E}$ le vecteur des $\tilde{N} - N$ composantes restantes. On a noté $\oplus$ l'addition du groupe agissant sur l'alphabet non-binaire du code, par exemple l'addition dans le corps de Galois $GF(q)$. On rappelle que cette addition n'est autre que l'opération *XOR* (OU exclusif) dans le cas binaire ($q = 2$).

Dans la suite nous référerons à une opération de fractionnement telle que définie en (26) et (27), y compris lorsqu'une nouvelle variable est ultérieurement insérée comme expliqué en relation avec (25).

Lorsque les conditions (26) et (27) sont vérifiées on dit également que les lignes $L_{i_1}, L_{i_2},...,L_{i_k}$ sont obtenues au moyen d'un « $k$-fractionnement » de la ligne $R_j$, $k$ étant un entier strictement supérieur à 1 indiquant le degré du fractionnement.

Enfin, on dira que la matrice $\tilde{H}$ est obtenue par fractionnement de la matrice $H$, s'il existe :

- une partition de l'ensemble des $\tilde{M}$ lignes de la matrice $\tilde{H}$ en $M$ sous-ensembles disjoints $\{L_{k_0},...,L_{k_1}\},\{L_{k_1+1},...,L_{k_2}\},...,\{L_{k_{M-1}+1},...,L_{k_M}\}$ avec $k_0 = 1$ et $k_M = \tilde{M}$ ;
- et un sous-ensemble $E \subseteq [1:\tilde{N}]$ de cardinal $N$ ;

tels que $\forall m \in \{1,...,M\}$ :

$$L_{k_{m-1}+1} \oplus L_{k_{m-1}+2} \oplus ... \oplus L_{k_m}\Big|_E = R_m \qquad (28)$$

et

$$L_{k_{m-1}+1} \oplus L_{k_{m-1}+2} \oplus ... \oplus L_{k_m}\Big|_{[1:\tilde{N}]\backslash E} = 0 \qquad (29)$$

où $R_m$ représente la $m$-ième ligne de $H$. On comprend ainsi qu'à la ligne $R_m$ de $H$ a été substituée une pluralité de nouvelles lignes $L_{k_{m-1}+1},...,L_{k_m}$.

On notera que les lignes $R_m$ ne sont pas nécessairement ordonnées de manière consécutive. De manière similaire, $\{L_1,...,L_{k_1}\}$ représente $k_1$ lignes distinctes quelconques de la matrice $\tilde{H}$, qui ne sont pas nécessairement consécutives. Il en est de même pour $\{L_{k_1+1},...,L_{k_2}\}$, etc.

$E$ représente l'ensemble des colonnes de $\tilde{H}$ déjà présentes dans la matrice $H$. L'ensemble $E$ est par conséquent l'ensemble des colonnes correspondant aux variables primaires (aux bits du code $C$ original s'il s'agit d'un code binaire) ou encore, par abus de langage, l'ensemble des variables primaires. De manière similaire, $[1:\tilde{N}]\backslash E$ est l'ensemble des variables supplémentaires introduites par le processus de fractionnement. Chaque colonne supplémentaire ajoutée à la matrice $H$ correspond à une variable supplémentaire, c'est-à-dire à un symbole supplémentaire n'appartenant pas au code $C$.

Le code $\tilde{C}$ défini par la matrice de parité $\tilde{H}$ est une extension du code $C$ au sens où si $X=(X_1,...,X_{\tilde{N}})$ est le mot du code $\tilde{C}$ alors $X|_E$ est un mot du code $C$. Autrement dit, si $\tilde{H}X^T = 0$ alors $HX|_E=0$.

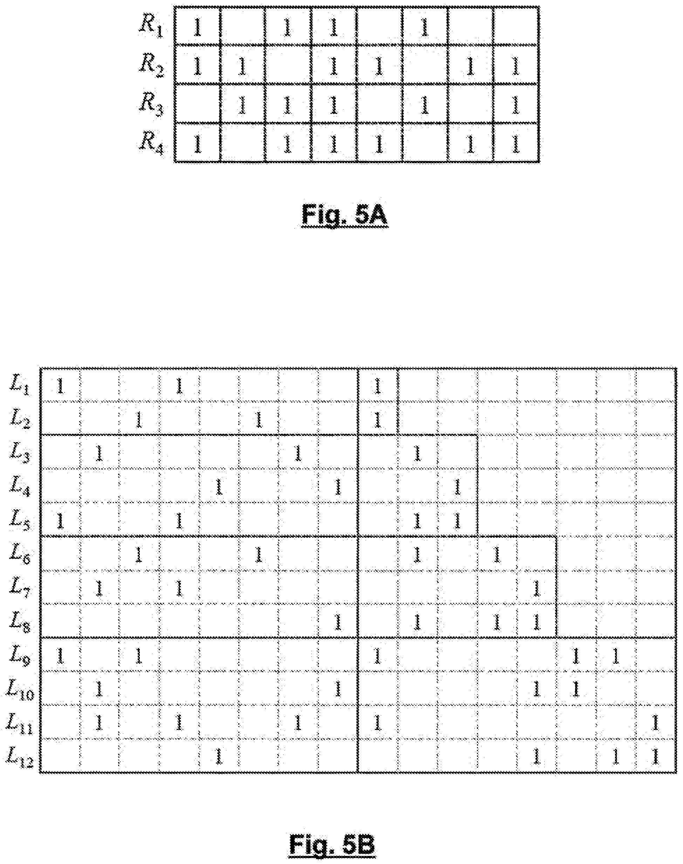

A titre d'illustration, on a représenté en Fig. 5A la matrice de parité $H$ d'un code et en Fig. 5B la matrice $\tilde{H}$ obtenue par fractionnement de cette matrice. On remarquera ici que :

- les lignes $L_1$ et $L_2$ de $\tilde{H}$ sont obtenues par un 2-fractionnement de la ligne $R_1$ de $H$ ;
- les lignes $L_3$, $L_4$ et $L_5$ de $\tilde{H}$ sont obtenues par un 3-fractionnement de la ligne $R_2$ de $H$ ;
- les lignes $L_6$, $L_7$ et $L_8$ de $\tilde{H}$ sont obtenues par un 3-fractionnement de la ligne $R_3$ de $H$ ;
- les lignes $L_9$, $L_{10}$, $L_{11}$ et $L_{12}$ de $\tilde{H}$ sont obtenues par un 4-fractionnement de la ligne $R_4$ de $H$.

On note également que la densité d'éléments non nuls de la matrice $\tilde{H}$ est sensiblement inférieure à celle de la matrice $H$: les bits d'une ligne de $H$ représentant un contrôle de parité sont désormais distribués sur plusieurs lignes.

De manière plus générale et, à la différence de l'état de la technique, la matrice de contrôle $\tilde{H}$ ne contient pas la matrice $H$ du code de départ. Le processus de fractionnement permet de réduire la densité d'éléments non nuls dans la matrice de contrôle en même temps que l'on accroît la redondance du code. Le processus de fractionnement permet en outre de rompre les cycles éventuellement présents dans la matrice $H$. Le code $\tilde{C}$ défini par la matrice de contrôle $\tilde{H}$ présente par conséquent une capacité de correction élevée associée à une convergence rapide du décodage.

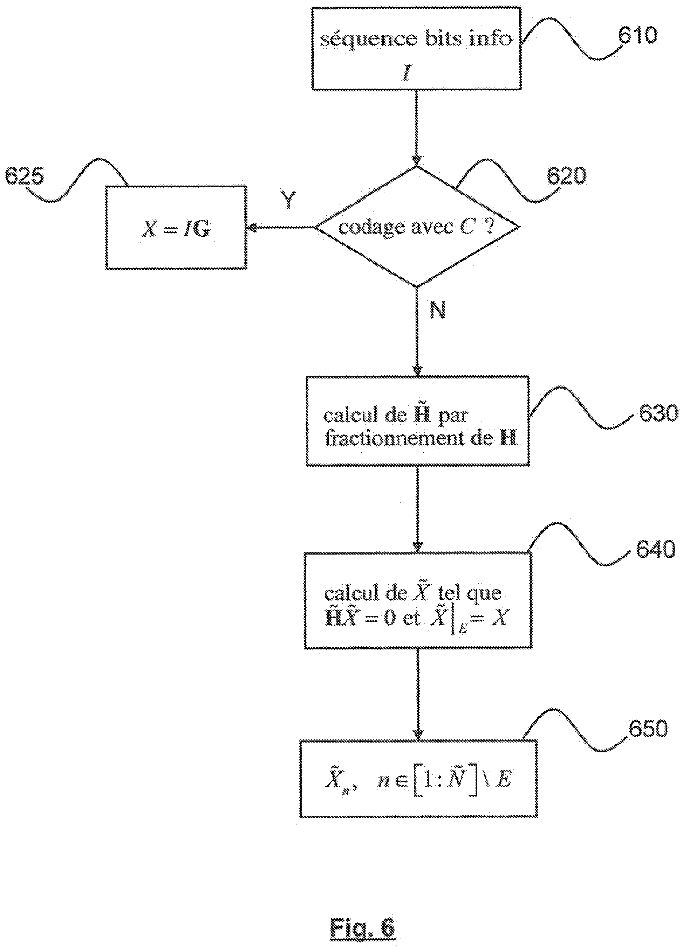

La Fig. 6 représente schématiquement une méthode de codage à redondance incrémentale selon un mode de réalisation de l'invention.

Cette méthode de codage utilise un code $C$ de type LDPC, défini par sa matrice de contrôle $H$ ou, de manière duale, par sa matrice génératrice **G.** On sait que l'on peut passer de l'une à l'autre au moyen de la relation **HG$^T$ = 0.** Dans le cas particulier où $C$ est un code systématique, on a **G=(I$_K$|P)** où $K$ est la dimension du code (nombre de bits d'information), **I$_K$** la matrice unité de taille $K \times K$ et **P** est une matrice de bits de parité de taille $K \times (N-K)$ où $N$ est la longueur du code. La matrice de contrôle peut s'écrire sous la forme **H = (-P$^T$|I$_{N-K}$),** soit encore dans le cas d'un code binaire **H = (P$^T$|I'$_{N-K}$)** où **I$_{N-K}$** est la matrice unité de taille $(N - K) \times (N - K)$.

A l'étape 610, on dispose de la séquence de symboles d'information à coder, $I,$ représentée sous forme vectorielle.

A l'étape 620, on détermine si l'on effectue le codage à l'aide du code initial $C$ ou à l'aide d'un code $\tilde{C}$ de rendement (ou débit) plus faible que $C$.

Si l'on peut se contenter d'un codage à l'aide de $C$, le mot de code $X = IG$ est fourni en 625. Dans le cas systématique $X=(I,P)$ où $P = IP$ est la séquence de parité.

A contrario, à l'étape 630, on calcule une matrice de contrôle $\tilde{H}$ par fractionnement de la matrice **H** comme vu précédemment. Différentes variantes peuvent être envisagées, selon que toutes les lignes de la matrice sont fractionnées ou certaines d'entre elles seulement le sont, ou bien encore selon que le degré de fractionnement diffère ou non d'une ligne à l'autre. Le nombre de lignes fractionnées peut dépendre de l'état de canal de transmission sur lequel les symboles d'information sont à transmettre. Alternativement ou cumulativement, le degré de fractionnement de ces lignes peut également dépendre de l'état du canal en question.

A l'étape 640, on code la séquence de symboles d'information à l'aide du code $\tilde{C}$ défini par la matrice $\tilde{H}.$ Pour ce faire on peut déterminer le mot de code $\tilde{X}$ de $\tilde{C}$ dont la restriction à $E$ est égale à $X$. On rappelle que $E$ est l'ensemble des colonnes de $\tilde{H}$ présentes dans **H**, autrement dit on détermine le vecteur $\tilde{X}$ tel que :

$$\tilde{\mathbf{H}}\tilde{X} = 0 \quad \text{et} \quad \tilde{X}\big|_E = X \qquad\qquad (30)$$

On fournit alors en 650 un incrément de redondance sous la forme de la séquence de symboles supplémentaires $\tilde{X}_n, n \in [1:\tilde{N}]\backslash E.$ Alternativement, on peut fournir en 650 (variante non représentée) la totalité des symboles composant $\tilde{X}.$

Le processus peut être itéré au sens où si le codage à l'aide de $\tilde{C}$ s'avère insuffisant, le fractionnement de la matrice **H** peut être poursuivi, soit en fractionnant des lignes non encore fractionnées, soit en augmentant le degré de fractionnement des lignes déjà fractionnées. Le fractionnement pourra se poursuivre avantageusement en partant de $\tilde{H}.$ On obtiendra ainsi des codes $\tilde{C}_1, \tilde{C}_2,...$ de redondance de plus en plus élevée et donc de rendement de plus en plus faible.

La méthode de codage à redondance incrémentale peut être mise en oeuvre par un ordinateur, et de manière plus générale par des moyens de calcul, distribués ou non.

Il est important de noter que le calcul de la matrice $\tilde{H}$ à partir de **H** peut être effectué dynamiquement par le codeur comme décrit précédemment ou bien avoir été préalablement effectué. En particulier, dans ce second cas, les matrices **H** et $\tilde{H}$ peuvent être stockées dans une mémoire du codeur.

La méthode de codage à redondance incrémentale peut s'appliquer à de nombreux systèmes de télécommunication ou autres.

Tout d'abord, elle peut être mise en oeuvre dans le cadre d'un système de télécommunication à adaptation de liaison. Comme on le sait, l'adaptation de liaison est effectuée grâce à la sélection d'un schéma de codage et de modulation ou MCS (*Modulation and Coding Scheme*) pour transmettre des données sur cette liaison. Le terminal destinataire renvoie au terminal source une information sur l'état du canal ou CSI (*Channel State Information*) libellée en termes de coefficient(s) d'atténuation du canal de transmission, de rapport signal sur bruit ou SNR (*Signal to Noise Ratio*) de taux d'erreurs bit ou BER (*Bit Error Rate*), de taux d'erreurs paquet PER (*Packet Error Rate*), etc.. Le terminal source sélectionne pour la transmission suivante le schéma MCS correspondant à l'état du canal. Un schéma MCS est un couple $(\sigma,\mu)$ constitué d'un code $\sigma$ et d'un alphabet de modulation $\mu$. Dans le cadre d'une méthode de transmission à adaptation de liaison selon un mode de réalisation de l'invention, le code $\sigma$ peut être sélectionné parmi une pluralité de codes $C, \tilde{C}_1, \tilde{C}_2,...$ où $C$ est un code LDPC et $\tilde{C}_1, \tilde{C}_2$ sont des codes de redondance croissante, obtenus par fractionnements successifs de $C$.

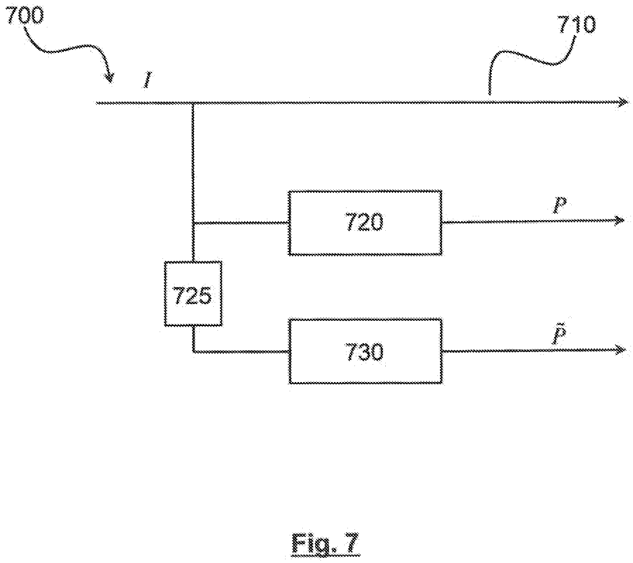

La méthode de codage à redondance incrémentale exposée précédemment peut être également appliquée à un système de turbocodage, comme représenté en Fig. 7.

Le turbocodeur 700 de la Fig. 7 comprend une branche 710 transmettant directement les bits d'information $I$, un premier codeur, 720, codant les bits d'informations $I$ à l'aide d'un code LDPC systématique, $C$, et ne fournissant que les bits de parité $P$, un second codeur, 730, recevant les bits d'information après entrelacement par l'entrelaceur 725 et utilisant un code $\tilde{C}$ obtenu par fractionnement de la matrice de contrôle **H** du code $C$ comme expliqué précédemment. Le second codeur fournit les bits de parité $\tilde{P}$ du code $\tilde{C}$ et le paquet encodé $(I,P,\tilde{P})$ est transmis sur le canal de transmission. Le degré de fractionnement du code $\tilde{C}$ peut être réglé de manière adaptative en fonction de l'état du canal de sorte que le paquet encodé présente un niveau de redondance variant de manière incrémentale.

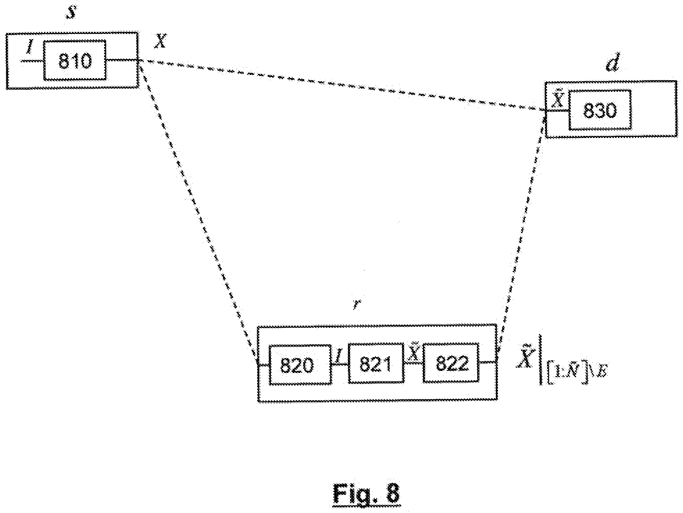

La méthode de codage à redondance incrémentale exposée précédemment peut aussi être mise à profit pour transmettre dans un réseau coopératif, comme représenté en Fig. 8.

Dans ce réseau, le terminal source ***s*** code en 810 un paquet de bits d'information, *I*, en utilisant un code LDPC, *C*, de matrice de contrôle **H.** Il génère ainsi un mot de code *X* et le transmet au terminal relais ***r*** ainsi qu'au terminal destinataire ***d***.

Le relais ***r*** décode en 820 les données reçues à l'aide de la matrice **H** en corrigeant les erreurs éventuelles de transmission. Il génère ensuite en 821 un mot de code $\tilde{X}$ tel que $\tilde{H}\tilde{X} = 0$ et $\tilde{X}|_E = X$ où $\tilde{H}$ est la matrice de contrôle obtenue par fractionnement de **H**. Les bits supplémentaires $\tilde{X}_n$, $n \in [1:\tilde{N}]\backslash E$ (où $E$ est l'ensemble des colonnes de $\tilde{H}$ présentes dans **H**) sont ensuite transmis en 822 au terminal destinataire.

Le terminal destinataire ***d*** reçoit du terminal source le paquet $X$ et du terminal relais le paquet $\tilde{X}|_{[1:\tilde{N}]\backslash E}$. Le terminal destinataire dispose par conséquent (puisque $X = \tilde{X}|_E$) du mot de code $\tilde{X}$ complet et peut le décoder en 830 en utilisant la matrice de contrôle $\tilde{H}$.

Dans le cas général, la méthode de codage peut utiliser une matrice **H** constituée d'éléments de *GF(q)*. Elle s'applique également que le code *C* soit systématique ou non.

Différentes variantes de réalisation de transmission coopérative peuvent être envisagées.

Tout d'abord, le terminal relais ***r*** peut transmettre l'entièreté du mot de code $\tilde{X}$ au lieu de se contenter de transmettre les bits supplémentaires. Le terminal destinataire reçoit alors $X = \tilde{X}|_E$ par deux canaux différents, ce qui permet d'améliorer la fiabilité de ces bits.

Alternativement, le terminal relais ***r*** peut transmettre, en sus des bits supplémentaires $\tilde{X}_n$, $n \in [1:\tilde{N}]\backslash E$, l'information *I* qu'il a décodée localement. Le terminal destinataire reçoit alors le mot de code $\tilde{X}$ ainsi que l'information systématique *I*. Cette variante permet d'augmenter le rapport signal sur bruit pour les bits d'information *I* et donc d'améliorer la fiabilité de ces bits.

Enfin, si une pluralité de terminaux relais ***r₁,...,r_L*** sont disponibles pour coopérer avec le terminal source, chaque terminal relais $r_\ell$ peut se charger de transmettre un sous-ensemble $\Lambda_\ell$ des bits supplémentaires $\tilde{X}_n$, $n \in [1:\tilde{N}]\backslash E$ de sorte que :

$$\left[1:\tilde{N}\right]\backslash E = \bigcup_{\ell=1}^{L}\Lambda_\ell \qquad\qquad (31)$$

Le terminal destinataire recevant les bits primaires du terminal source et les bits supplémentaires de l'ensemble des terminaux relais peut reconstituer le mot de code $\tilde{X}$ et le décoder à l'aide de la matrice de contrôle $\tilde{H}$.

Alternativement, comme précédemment, chacun des terminaux relais $r_\ell$, $\ell = 1,...,L$, pourra transmettre en sus de sa partie $\Lambda_\ell$ des bits supplémentaires, l'information *I* qu'il aura décodée localement. On augmente ainsi significativement le rapport signal sur bruit pour les bits d'information *I* et l'on améliore donc encore la fiabilité de ces bits.

Dans l'application de la méthode de codage selon l'invention à un réseau coopératif, on a supposé que le code $\tilde{C}$ était défini par un fractionnement prédéterminé de la matrice **H**. Toutefois, ce fractionnement peut être adaptatif, et varier par exemple en fonction de l'état du canal entre le terminal relais ***r*** et le terminal destinataire ***d*** et/ou l'état du canal entre le terminal source ***s*** et le terminal destinataire ***d***. Plus précisément, le relais peut augmenter le degré de redondance du code $\tilde{C}$ en fractionnant davantage la matrice **H** si l'état du canal ***r-d*** et/ou du canal ***s-d*** se dégrade. Le contrôle du fractionnement peut être réalisé à l'initiative du terminal relais ou bien sous contrôle du terminal source.

Lorsque plusieurs terminaux relais ***r₁,...,r_L*** interviennent de manière coopérative dans la transmission, chaque terminal relais $r_\ell$ peut se voir attribuer de manière dynamique un sous-ensemble $\Lambda_\ell$ de taille plus ou moins grande en fonction de la qualité du canal $r_\ell$-***d***. En outre, il est possible de faire varier également le degré de redondance du code C, en fractionnant plus ou moins la matrice de contrôle $\tilde{H}$, pour tenir compte de la qualité globale du canal relais. Le contrôle du fractionnement ainsi que de la répartition des $\Lambda_\ell$ est avantageusement réalisé de manière centralisée par le terminal source.

La méthode de codage à redondance incrémentale selon l'invention peut enfin être utilisée dans un système de transmission IR-HARQ. Un terminal source d'un tel système transmet une première fois un paquet de bits d'information *I* en le codant au moyen d'un code LDPC, *C*, de matrice de contrôle **H.** En d'autres termes le terminal source transmet un mot de code *X* représentant le paquet *I*. Si le terminal destinataire arrive à décoder le paquet *X*, le cas échéant en corrigeant des erreurs éventuelles de transmission grâce à la matrice de contrôle **H,** le terminal source poursuit la transmission avec le paquet de bits d'information suivant. En revanche, si le paquet ne peut être décodé, le terminal destinataire requiert une retransmission au terminal source. Celui-ci procède alors à un second codage du paquet *I* à l'aide d'un code $\tilde{C}$ de matrice de contrôle $\tilde{H}$ obtenue par fractionnement de **H** comme expliqué plus haut et transmet seulement les bits supplémentaires $\tilde{X}_n$, $n \in [1:\tilde{N}]\backslash E$, *où E* est l'ensemble des colonnes de $\tilde{H}$ déjà présentes dans **H**. Si le décodeur n'arrive toujours pas à décoder le paquet avec succès, le processus de codage incrémental peut être itéré.

Autrement dit, le terminal source peut coder le paquet à l'aide de codes $\tilde{C}_1$, $\tilde{C}_2$,... redondance croissante, obtenus par fractionnements successifs de la matrice de parité de $C$. Plus précisément, la matrice $\tilde{H}$ peut être elle-même fractionnée pour fournir une nouvelle matrice de contrôle $\tilde{H}_1$ définissant un nouveau code $\tilde{C}_1$. A nouveau, seuls les bits supplémentaires $\tilde{X}_n$, $n \in [1:\tilde{N}_1]$-$E_1$, où $E_1$ est l'ensemble des colonnes de $\tilde{H}_1$ déjà présentes dans $\tilde{H}$ sont transmis par le terminal source.

Dans les exemples d'application de l'invention précédemment décrits, la matrice $\tilde{H}$ peut être calculée dynamiquement à partir de la matrice $H$ ou bien avoir été préalablement calculée. Dans ce second cas, les matrices $H$ et $\tilde{H}$ peuvent notamment être stockées en mémoire.

## Revendications

1. Méthode de codage à redondance incrémentale utilisant un turbocode, dans laqelle :

    - on fournit un paquet de symboles d'information $I$ sous forme systématique dans une première branche du turbocode et l'on code ledit paquet à l'aide d'un premier code systématique $C$, de type LDPC, défini par une première matrice de contrôle $H$ ;
    - on fournit dans une seconde branche du turbocode les symboles de parité du paquet ainsi encodé et l'on code ledit paquet, après l'avoir entrelacé, à l'aide d'un second code $\tilde{C}$, défini par une seconde matrice de contrôle $\tilde{H}$ ; et
    - on fournit dans une troisème branche du turbocode les symboles de parité du paquet ainsi encodé, **caractérisée en ce que**

    ladite seconde matrice de contrôle est obtenue en fractionnant au moins un contrôle de parité représenté par une ligne de la matrice $H$ en une pluralité de contrôles de parité partiels portant sur des symboles du premier code et au moins un symbole supplémentaire, en ajoutant à cette matrice au moins une nouvelle colonne représentant ledit symbole supplémentaire, et en substituant à ladite ligne de nouvelles lignes représentant respectivement ces contrôles de parité partiels, de sorte que des cycles présents dans la première matrice de contrôle soient rompus dans la seconde matrice de contrôle.

2. Méthode de transmission de paquets dans un réseau de transmission de type coopératif comprenant un terminal source, un terminal destinataire et au moins un terminal relais, ladite méthode de transmission mettant en oeuvre de codage à redondance incrémentale selon la revendication 1, **caractérisée en ce que** :

    - le terminal source code un paquet de symboles d'information, $I$, en utilisant le premier code, $C$, et transmet le paquet ainsi encodé au terminal relais ainsi qu'au terminal destinataire ;
    - le terminal relais décode les données reçues pour récupérer ledit paquet et code le paquet récupéré à l'aide du second code $\tilde{C}$, après l'avoir entrelacé ;
    - le terminal relais transmet au terminal destinataire au moins les symboles supplémentaires correspondant aux colonnes de la seconde matrice de contrôle qui ne sont pas présentes dans la première matrice de contrôle.

3. Méthode de transmission selon la revendication 2, **caractérisée en ce que** le terminal relais transmet la totalité des symboles du paquet codé par le second code.

4. Méthode de transmission selon la revendication 2 ou 3, **caractérisée en ce que** le terminal relais transmet également au terminal destinataire ledit paquet récupéré.

5. Méthode de transmission selon l'une des revendications 2 à 4, **caractérisée en ce que** le nombre de lignes fractionnées et/ou leur degré de fractionnement sont/est fonction de l'état du canal de transmission entre le terminal relais et le terminal destinataire et/ou l'état du canal de transmission entre la source et le destinataire.

6. Méthode de transmission de paquets dans un réseau de transmission de type coopératif comprenant un terminal source, un terminal destinataire et une pluralité de terminaux relais, ladite méthode de transmission mettant en oeuvre un codage à redondance incrémentale selon la revendication 1, **caractérisée en ce que** :

    - le terminal source code le paquet de symboles d'information, $I$, en utilisant le premier code, $C$, et transmet le paquet ainsi encodé aux terminaux relais ainsi qu'au terminal destinataire ;
    - chaque terminal relais décode les données reçues pour récupérer ledit paquet et code le paquet récupéré, après l'avoir entrelacé à l'aide d'un second code défini par une matrice de contrôle, cette matrice de contrôle étant obtenue à partir de **H** en fractionnant au moins un contrôle de parité représenté par une ligne de la matrice **H** en une pluralité de contrôles de parité partiels portant sur des symboles du premier code et un ensemble de symboles supplémentaires, en ajoutant à la matrice **H** une pluralité de colonnes représentant cet ensemble de symboles supplémentaires et en substituant à ladite ligne de nouvelles lignes représentant respectivement ces contrôles de parité partiels ;

- chaque terminal relais transmet au terminal destinataire un sous-ensemble des symboles supplémentaires correspondant aux colonnes de la seconde matrice de contrôle qui ne sont pas présentes dans la première matrice de contrôle, les sous-ensembles de deux relais distincts étant disjoints.

**7.** Méthode de transmission de paquets selon la revendication 6, **caractérisée en ce que** les tailles des différents sous-ensembles sont déterminées de manière centralisée par le terminal source.

**8.** Méthode de transmission de paquets selon la revendication 6 ou 7, **caractérisée en ce que** la réunion desdits sous-ensembles constitue ledit ensemble de symboles supplémentaires et que la taille du dit ensemble est déterminée par le terminal source.

**Patentansprüche**

**1.** Kodierverfahren mit inkrementaler Redundanz unter Verwendung eines Turbocodes, bei dem:

- man ein Paket von Informationssymbolen I in systematischer Form in einem ersten Zweig des Turbocodes liefert, und man das Paket mit Hilfe eines ersten systematischen Codes C vom Typ LDPC kodiert, definiert durch eine erste Kontrollmatrix **H;**
- man in einem zweiten Zweig des Turbocodes die Paritätssymbole des derart kodierten Pakets liefert, und man das Paket, nachdem man es verschachtelt hat, mit Hilfe eines zweiten Codes $\tilde{C}$ kodiert, definiert durch eine zweite Kontrollmatrix $\tilde{H}$;
- man in einem dritten Zweig des Turbocodes die Paritätssymbole des derart kodierten Pakets liefert, **dadurch gekennzeichnet, dass**

die zweite Kontrollmatrix erhalten wird durch Fraktionieren wenigstens einer Paritätskontrolle, repräsentiert durch eine Zeile der Matrix **H,** in eine Mehrzahl von partiellen Paritätskontrollen, die sich auf Symbole des ersten Codes und wenigstens ein zusätzliches Symbol beziehen, indem man zu dieser Matrix wenigstens eine neue Spalte hinzufügt, die das zusätzliche Symbol repräsentiert, und indem man für die Zeile neue Zeilen substituiert, die jeweils diese partiellen Paritätskontrollen repräsentieren, derart, dass in der ersten Kontrollmatrix vorhandene Zyklen in der zweiten Kontrollmatrix durchbrochen sind.

**2.** Verfahren zur Übertragung von Paketen in einem Übertragungsnetz vom kooperativen Typ, umfassend ein Quellenterminal, ein Zielterminal und wenigstens ein Relaisterminal, wobei das Übertragungsverfahren die Kodierung mit inkrementaler Redundanz nach Anspruch 1 verwendet, **dadurch gekennzeichnet, dass**:

- das Quellenterminal ein Paket von Informationssymbolen I unter Verwendung des ersten Codes C kodiert und das somit kodierte Paket an das Relaisterminal sowie an das Zielterminal überträgt;
- das Relaisterminal die empfangenen Daten dekodiert, um das Paket wiederzugewinnen, und das wiedergewonnene Paket, nachdem es verschachtelt wurde, mit Hilfe des zweiten Codes $\tilde{C}$ kodiert;
- das Relaisterminal an das Zielterminal wenigstens die zusätzlichen Symbole überträgt, die den Spalten der zweiten Kontrollmatrix entsprechen, die in der ersten Kontrollmatrix nicht vorhanden sind.

**3.** Übertragungsverfahren nach Anspruch 2, **dadurch gekennzeichnet, dass** das Relaisterminal die Gesamtheit der Symbole des durch den zweiten Code kodierten Pakets überträgt.

**4.** Übertragungsverfahren nach Anspruch 2 oder 3, **dadurch gekennzeichnet, dass** das Relaisterminal an das Zielterminal auch das wiedergewonnene Paket überträgt.

**5.** Übertragungsverfahren nach einem der Ansprüche 2 bis 4 **dadurch gekennzeichnet**, das die Zahl der fraktionierten Zeilen und/ oder ihr Fraktionierungsgrad eine Funktion des Zustands des Übertragungskanals zwischen dem Relaisterminal und dem Zielterminal und/ oder des Zustands des Übertragungskanals zwischen der Quelle und dem Ziel ist/ sind.

**6.** Verfahren zur Übertragung von Paketen in einem Übertragungsnetz vom kooperativen Typ, umfassend ein Quellenterminal, ein Zielterminal und eine Mehrzahl von Relaisterminals, wobei das Übertragungsverfahren eine Kodierung mit inkrementaler Redundanz nach Anspruch 1 verwendet, **dadurch gekennzeichnet, dass**:

- das Quellenterminal das Paket von Informationssymbolen I unter Verwendung des ersten Codes C kodiert, und das derart kodierte Paket an die Relaisterminals sowie an das Zielterminal überträgt;
- jedes Relaisterminal die empfangenen Daten dekodiert, um das Paket wiederzugewinnen, und das wiedergewonnene Paket mit Hilfe eines zweiten Codes kodiert, nachdem es verschachtelt wurde, der durch eine Kontrollmatrix definiert ist, wobei diese Kontrollmatrix erhalten wird ausgehend von **H** durch Fraktionieren wenigstens einer Paritätskontrolle, die durch eine Zeile der Matrix **H** repräsentiert ist, in eine Mehrzahl von partiellen Paritätskontrollen, die sich auf Symbole des ersten Codes und eine Gesamtheit von zusätzlichen Symbolen beziehen, indem man zu der Matrix **H** eine Mehrzahl von Spalten hinzufügt, die diese Gesamtheit von zusätzlichen Symbolen repräsentieren, und man für die Zeile neue Zeilen substituiert, die jeweils diese partiellen Paritätskontrollen repräsentieren;
- jedes Relaisterminal an das Zielterminal eine Untergesamtheit der zusätzlichen Symbole überträgt, die den Spalten der zweiten Kontrollmatrix entspricht, die nicht in der ersten Kontrollmatrix vorhanden sind, wobei diese Untergesamtheiten von zwei verschiedenen Relais disjunkt sind.

**7.** Verfahren zur Übertragung von Paketen nach Anspruch 6, **dadurch gekennzeichnet, dass** die Größen der verschieden Untergesamtheiten auf zentralisierte Weise durch das Quellenterminal bestimmt werden.

**8.** Verfahren zur Übertragung von Paketen nach Anspruch 6 oder 7, **dadurch gekennzeichnet, dass** die Wiedervereinigung der Untergesamtheiten die Gesamtheit von zusätzlichen Symbolen bildet, und dass die Größe der Gesamtheit durch das Quellenterminal bestimmt wird.

**Claims**

**1.** An incremental redundant coding method using a turbo-code, in which:

- a packet of information symbols $I$ is supplied under systematic form to a first branch of said turbo-code, said packet being encoded using a first systematic code $C$, of the LDPC type, defined by a first check matrix **H;**
- the parity symbols in the packet thus encoded are supplied to a second branch of the turbo-code, said packet being encoded, after interleaving, using a second code $\tilde{C}$, defined by a second check matrix $\tilde{\mathbf{H}}$;
- the parity symbols of the packet thus encoded are supplied to a third branch of the turbo-code, **characterised in that**:

said second check matrix is obtained by fractionating at least one parity check represented by a row of matrix **H** into a plurality of partial parity checks applying to the symbols of the first code and at least one additional symbol, by adding to this matrix at least one new column representing said additional symbol and by substituting for said row new rows respectively representing these partial parity checks, so that cycles present in the first check matrix are broken in the second check matrix.

**2.** A method for transmitting packets within a communication network of the cooperative type including a source terminal, a destination terminal and at least one relay terminal, said method for transmitting using an incremental redundant coding method according to claim 1, **characterised in that**:

- the source terminal encodes a packet of information symbols, $I$, using a first code, $C$, of the LDPC type and with check matrix **H,** and transmits the packet thus encoded to the relay terminal as well as to the destination terminal;
- the relay terminal decodes the received data to recover said packet and encodes the recovered packet using said second code $\tilde{C}$, after having interleaving;
- the relay terminal transmits to the destination terminal at least the additional symbols corresponding to the columns of the second check matrix which are not present in the first check matrix.

**3.** A method of transmission according to claim 2, **characterised in that** the relay terminal transmits all the symbols of the packet encoded with the second code.

**4.** A transmission method according to claim 2 or 3, **characterised in that** the relay terminal also transmits said recovered packet to the destination terminal.

**5.** A transmission method according to one of claims 2 through 4, **characterised in that** the number of fractionated rows and/or their degree of fractionation is/are dependent on the state of the communication channel between the relay terminal and the destination terminal and/or the state of the communication channel between the source and the destination.

**6.** A method for transmitting packets within a cooperative type communication network including a source terminal, a destination terminal and a plurality of relay terminals, said method for transmitting using an incremental redundant coding method according to claim 1, **characterised in that**:

- the source terminal encodes the packet of information symbols, *I,* using the first code, *C*, and transmits the packet thus encoded to the relay terminals as well as to the destination terminal;
- each relay terminal decodes the received data to recover said packet and encodes the recovered packet using a second code defined by a check matrix, said check matrix being obtained from **H** by fractionating at least one parity check represented by a row of matrix **H** into a plurality of partial parity checks applying to symbols of the first code and a set of additional symbols, by adding to matrix **H** a plurality of columns representing this set of additional symbols and by substituting for said row new rows respectively representing these partial parity checks;
- each relay terminal transmits to the destination terminal a subset of the additional symbols corresponding to the columns of the second check matrix which are not present in the first check matrix, the subsets of two distinct relays being disjoint.

**7.** A packet transmission method according to claim 6, **characterised in that** the sizes of the various subsets are determined centrally by the source terminal.

**8.** A packet transmission method according to claim 6 or 7, **characterised in that** the recombination of said subsets constitutes said set of additional symbols and the size of said set is determined by the source terminal.

$$\mathbb{H} = \begin{pmatrix} 1 & 1 & 1 & 1 & 0 & 0 \\ 0 & 1 & 0 & 1 & 1 & 1 \\ 1 & 0 & 1 & 0 & 1 & 1 \end{pmatrix}$$

Fig. 1

$I$

$\Pi_1$

$\Pi_2$

$RSC_1$    $P_1$    $sw_1$

$RSC_2$    $P_2$    $sw_2$

$RSC_3$    $P_3$    $sw_3$

**Fig. 2**

Fig. 3

EP 2 341 628 B1

**Fig. 4A**

**Fig. 4B**

| | | | | | | | |
|---|---|---|---|---|---|---|---|
| $R_1$ | 1 | | 1 | 1 | | 1 | | |
| $R_2$ | 1 | 1 | | 1 | 1 | | 1 | 1 |
| $R_3$ | | 1 | 1 | 1 | | 1 | | 1 |
| $R_4$ | 1 | | 1 | 1 | 1 | | 1 | 1 |

**Fig. 5A**

| | | | | | | | | | | | | | | | | |
|---|---|---|---|---|---|---|---|---|---|---|---|---|---|---|---|---|
| $L_1$ | 1 | | | 1 | | | | 1 | | | | | | | | |
| $L_2$ | | 1 | | | 1 | | | 1 | | | | | | | | |
| $L_3$ | | 1 | | | | 1 | | | 1 | | | | | | | |
| $L_4$ | | | | 1 | | | 1 | | | 1 | | | | | | |
| $L_5$ | 1 | | | 1 | | | | | 1 | 1 | | | | | | |
| $L_6$ | | | 1 | | | 1 | | | 1 | | 1 | | | | | |
| $L_7$ | | 1 | | 1 | | | | | | | | 1 | | | | |
| $L_8$ | | | | | | 1 | | | 1 | | 1 | 1 | | | | |
| $L_9$ | 1 | | 1 | | | | | 1 | | | | | 1 | 1 | | |
| $L_{10}$ | | 1 | | | | | 1 | | | | | 1 | 1 | | | |
| $L_{11}$ | | 1 | | 1 | | | 1 | 1 | | | | | | | | 1 |
| $L_{12}$ | | | | | 1 | | | | | | | 1 | | | 1 | 1 |

**Fig. 5B**

séquence bits info
$I$ — 610

codage avec $C$ ? — 620

Y

$X = I\mathbb{G}$ — 625

N

calcul de $\tilde{\mathbf{H}}$ par fractionnement de $\mathbf{H}$ — 630

calcul de $\tilde{X}$ tel que $\tilde{\mathbf{H}}\tilde{X} = 0$ et $\tilde{X}\big|_{E} = X$ — 640

$\tilde{X}_{n}, \quad n \in \left[1 : \tilde{N}\right] \setminus E$ — 650

Fig. 6

700 710

$I$

720 $P$

725

730 $\tilde{P}$

**Fig. 7**

$s$

$I$

810

$X$

$d$

$\breve{X}$

830

$r$

820  $I$  821  $\breve{X}$  822

$\tilde{X}\big|_{[1:\tilde{N}]\setminus E}$

**Fig. 8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1531552 A

**Littérature non-brevet citée dans la description**

- **R. GALLAGER.** Low density parity check codes. *IEEE Trans. Inform. Theory,* 1962, vol. IT-8, 21-28
- **N. WIBERG.** *Codes and decoding on general graphs,* 1996
- **V. SAVIN.** Min-Max decoding for non-binary LDPC codes. *IEEE Symposium on Information Theory (ISIT),* 2008
- **B. ZHAO et al.** Distributed turbo coded diversity for the relay channel. *IEEE Electronics Letters,* Mai 2003, vol. 39, 786-787
- **P. RAZAGHI et al.** Bilayer low-density parity check codes for decode-and-forward. *IEEE Trans. on Information Theory,* Octobre 2007
- **B. BEHAIRY et al.** Parallel concatenated Gallager codes. *Electronics Letters,* 23 Novembre 2000, vol. 36 (24), 2025-2026